# EUROPÄISCHE PATENTSCHRIFT

(11) **EP 0 823 148 B1**
(45) Veröffentlichungstag und Bekanntmachung des Hinweises auf die Patenterteilung: **19.01.2000**
(21) Anmeldenummer: 96909070.3
(22) Anmeldetag: 19.04.1996
(51) Int. Cl.: H03K 19/017

(54) **GTL-AUSGANGSVERSTÄRKER ZUM EINKOPPELN EINES AM EINGANG ANLIEGENDEN EINGANGSSIGNALES IN EINE AM AUSGANG ANLIEGENDE ÜBERTRAGUNGSLEITUNG**
GTL OUTPUT AMPLIFIER FOR COUPLING AN INPUT SIGNAL AT THE INPUT TO A TRANSMISSION LINE AT THE OUTPUT
AMPLIFICATEUR DE SORTIE GTL POUR INJECTER UN SIGNAL D'ENTREE SE TROUVANT A UNE ENTREE DANS UNE LIGNE DE TRANSMISSION SITUEE A LA SORTIE

(30) Priorität: 28.04.1995 DE 19515800
(43) Veröffentlichungstag der Anmeldung: 11.02.1998
(73) Patentinhaber: SIEMENS AKTIENGESELLSCHAFT, 80333 München (DE)
(72) Erfinder: TERLETZKI, Hartmud, D-81827 München (DE)
(86) Internationale Anmeldenummer: DE9600693
(87) Internationale Veröffentlichungsnummer: WO9634458

(56) Entgegenhaltungen:
- EP-A- 0 047 128
- EP-A- 0 216 178
- GB-A- 2 244 613
- US-A- 5 410 189
- PATENT ABSTRACTS OF JAPAN vol. 16, no. 048 (E-1163), 6.Februar 1992 & JP,A,03 250813 (HITACHI LTD), 8.November 1991,
- PATENT ABSTRACTS OF JAPAN vol. 014, no. 489 (E-0994), 24.Oktober 1990 & JP,A,02 202222 (MITSUBISHI ELECTRIC CORP), 10.August 1990,
- IEEE INTERNATIONAL SOLID STATE CIRCUITS CONFERENCE, Bd. 35, 1.Februar 1992, Seiten 58-59, XP000315421 GUNNING B ET AL: "A CMOS LOW-VOLTAGE-SWING TRANSMISSION-LINE TRANSCEIVER" in der Anmeldung erwähnt
- PATENT ABSTRACTS OF JAPAN vol. 6, no. 115 (E-115) [993] , 26.Juni 1982 & JP,A,57 045717 (TOKYO SHIBAURA DENKI K.K.), 15.März 1982,
- PATENT ABSTRACTS OF JAPAN vol. 95, no. 005 & JP,A,07 121276 (NIPPON TELEGR & TELEPH CORP), 12.Mai 1995,

## Beschreibung

Eingangs-/Ausgangsschaltungen von Halbleiterbausteinen oder Chips sind das Bindeglied zwischen den chipinternen und chipexternen Signalpegeln oder Signalen. Die Anzahl der Eingangs/Ausgangsschaltungen hängt dabei von der Funktion des Chips ab. Eingangs-/Ausgangsports in der Größenordnung von 100 Anschlüssen pro Chip, z. B. in digitalen Vermittlungsstellen, sind heute keine Seltenheit mehr. Breite Busleitungen auf den Leiterplatten (Boards) verbinden die einzelnen Komponenten eines Systems miteinander. Die Tendenz geht dabei zu immer hochfrequenteren Übertragungsraten über die Übertragungsleitungen des Busses. Aufgrund der Störsicherheit werden die hochfrequenten Signale zusatzlich komplementär übertragen, was die Anzahl der Eingangs-/Ausgangsports noch einmal verdoppelt.

Herkömmliche CMOS-Ausgangsverstärker (CMOS-Buffer) kommen aufgrund der schlechten Signalqualität (Über-/Unterschwinger) und des hohen Spannungshubes für Hochfrequenzanwendungen(> 100 bis 500 MHz) nicht in Frage. Hochfrequente Signale werden üblicherweise in ECL-Technik mit abgeschlossenen 50 Ω Übertragungsleitungen übertragen. Durch abgeschlossene 50 Ω Leitungen werden Reflexionen und damit Verzerrungen der Signale bei der Übertragung über die Leitung vermieden. Ein Nachteil der ECL-Technik ist die relativ hohe Verlustleistung, die, je nach Anzahl der Eingangs-/Ausgangsports, zum bestimmenden Faktor der Gesamtverlustleistung eines Bausteins werden kann.

Zur Verringerung der chipinternen Verlustleistung ist die bei verschiedenen Standards (ECL-Standard = Emitter Coupled Logic; GTL-Standard = Gunning Transeiver Logic; CTT-Standard = Center Tap Terminated Digital Interface) angewandte open-collector Technik hilfreich. Hier wird ein Teil der Verlustleistung auf einen externen Widerstand verlagert. Der Nachteil der open-collector bzw. open-drain Technik ist jedoch die eingeschränkte Hochfrequenztauglichkeit, da je nach externem Widerstand und Lastkapazität der Signalanstieg am Ausgang begrenzt ist. Der pull-down Transistor des Ausgangsverstärkers kann zwar so dimensioniert werden, daß die Lastkapazität der Leitung in angemessener Zeit entladen wird. Die Anstiegszeit für den hohen(High) Pegel wird jedoch durch die RC-Zeit des externen Widerstandes und der Lastkapazitat bestimmt. Wird der externe Widerstand als 50 Ω Abschlußwiderstand zur Vermeidung von Leitungsreflexionen realisiert, wie z.B. von B. Gunning (B.Gunning, "CMOS Low-Voltage-Swing Transmission-Line Transceiver", ISSCC 92, Seiten 58 bis 59) vorgeschlagen, reicht eine Last von 2,5 pF aus, um die Schaltfrequenz auf ca. 500 MHz zu begrenzen.

Das der Erfindung zugrunde liegende Problem besteht darin, einen GTL-Ausgangsverstärker zum Einkoppeln eines am Eingang anliegenden Eingangssignales in eine am Ausgang anliegende Übertragungsleitung anzugeben, durch den auch hochfrequente Signale auf die Übertragungsleitung geschaltet werden können.

Diese Aufgabe wird gemäß den Merkmalen des Patentanspruchs 1 gelöst.

Weiterbildungen der Erfindung ergeben sich aus den abhängigen Ansprüchen.

Der erfindungsgemäße Ausgangsverstarker verwendet zusätzlich zu dem pull-down Transistor eine pull- up Transistorschaltung, die nur bei Änderung des Eingangssignales von einem ersten Wert zu einem zweiten Wert ein zweites Potential an den Ausgang legt.

Die Verzögerungsmittel zum Ansteuern der pull-up Transistorschaltung sollte auf die Lastkapazitat der am Ausgang anliegenden Leitung abgestimmt sein, um ein Über- oder Unterladen des Ausgangs zu vermeiden. Um die Verzögerung genau auf die Aufladezeit der Lastkapazität abzustimmen, ist in der pull-up Transistorschaltung eine Regelschaltung vorgesehen, die den pull-up Zweig genauso lange öffnet, bis die Lastkapazität aufgeladen ist.

Weiterhin kann ein Überlastschutz dadurch erreicht werden, daß die pull-up Transistorschaltung im Überlastfall abgeschaltet wird und damit eine Überlastung des Bausteins vermieden wird.

Anhand von Ausführungsbeispielen, die in den Figuren dargestellt sind, wird die Erfindung weiter erläutert.

Es zeigen
Figur 1 den GTL-Ausgangsverstärker mit einer pull-up Transistorschaltung,
Figur 2 eine Variation des Ausgangsverstärkers nach Figur 1,
Figur 3 den Ausgangsverstärker mit einer Regelschaltung innerhalb der pull-up Transistorschaltung,
Figur 4 einen weiteren Ausgangsverstärker mit Regelschaltung,
Figur 5 den Ausgangsverstärker mit Überlastschutz
Figur 6 ein Diagramm, das die Abhängigkeit des Ausgangssignales von der Zeit t für die Schaltung von Figur 1 darstellt.

In den folgenden Figuren sind gleiche Bauelemente mit gleichen Bezugszeichen benannt.

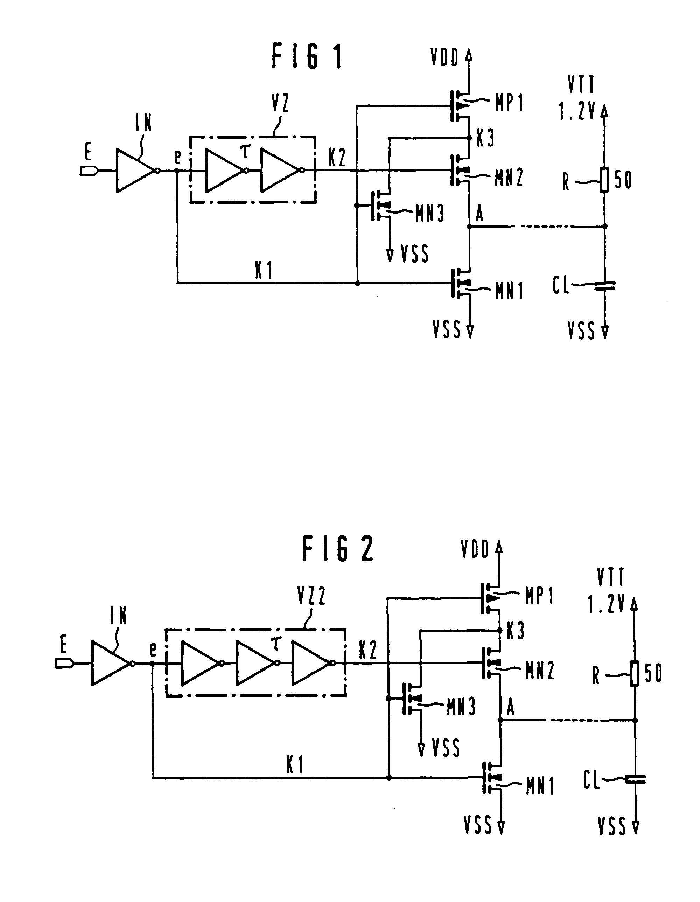

Figur 1 zeigt einen GTL-Ausgangsverstarker AV, an dessen Ausgang A eine Leitung angeschlossen ist, die z.B. mit einem Widerstand R von 50 Ω abgeschlossen ist. In Figur 1 ist weiterhin die Lastkapazitat CL der Leitung dargestellt. Am Eingang E des Ausgangsverstärkers AV wird ein Eingangssignal E, z.B.ein binäres Signal zugeführt. Dieses kann invertiert werden durch einen Inverter IN. Das Potential am Ausgang A wird festgelegt einerseits durch einen pull-down Transistor MN1, der den Ausgang A auf ein erstes Potential legt, wenn er leitend gesteuert ist. Weiterhin enthält der Ausgangsverstärker AV eine pull- up Transistorschaltung, bestehend im Ausführungsbeispiel aus den Transistoren MP1 und MN2. Wenn beide Transistoren leitend gesteuert sind, dann legt diese pull- up Transistorschaltung ein zweites Potential an den Ausgang A. Am Eingang des Transistors MP1 liegt das invertierte Eingangssignal e an, das auch am pull-down Transistor MN1 angelegt ist. Am Eingang des Transistors MN2 der pull-up Transistorschaltung liegt das invertierte Eingangssignal e verzögert durch eine Verzögerungsschaltung VZ1 an. Schließlich ist noch ein Transistor MN3 vorgesehen, der ebenfalls vom invertierten Eingangssignal e angesteuert wird und der am Verbindungspunkt der Serienschaltung der Transistoren MP1 und MN2 der pull- up Transistorschaltung angeschlossen ist.

Die Schaltung bezieht sich auf Anwendungen nach dem GTL-Standard. Die Spannungspegel am Ausgang der Schaltung sind 1,2 Volt für den logischen Zustand HIGH und 0,4 Volt für den logischen Zustand LOW.

Die pull-up Transistorschaltung MP1, MN2 ist so geschaltet, daß sie ausschließlich in der Übergangsphase des invertierten Eingangssignals e vom einen Wert zum anderen Wert nur kurzzeitig eingeschaltet ist und dadurch die Lastkapazität CL umlädt.In dieser Übergangsphase schaltet auch der Ausgang A vom ersten Potential zum zweiten Potential. Damit sorgt die pull-up Transistorschaltung für eine rasche Aufladung der Last, während anschließend der High-Pegel auf der Leitung durch den externen Widerstand R gehalten wird. Dieser externe Widerstand R ist zur Anpassung an die 50 Ω Übertragungsleitung auf dem Board als 50 Ω Abschlußwiderstand ausgelegt. Figur 1 zeigt schematisch die Schaltung mit externer Lastkapazität CL und 50 Ω Widerstand R,an dem das Potential V_{TT} anliegt.

Diese Schaltung bietet den Vorteil, daß die 50 Ω Übertragungsleitung in der Übergangsphase über die Transistoren MN2 und MP1 am Ausgang A impedanzmäßig abgeschlossen ist und somit keine Spannungsüberhöhung durch Reflexionen der Übertragungsleitung auftreten.

Im folgenden wird die Funktion des Ausgangsverstärkers nach Figur 1 erläutert:
Es wird angenommen, daß der logische Zustand am Knoten K1, der dem invertierten Eingangssignal e entspricht, "1" ist. Dann ist der logische Zustand am Knoten K2 am Ausgang der Verzögerungsschaltung VZ1 ebenfalls "1".

Die Folge ist, daß die Transistoren MN1, MN2 und MN3 eingeschaltet sind und damit der Ausgang A den Zustand "0" hat. Vom Ausgang A her betrachtet liegt die Reihenschaltung aus Transistor MN2 und MN3 parallel zum pull-down Transistor MN1. Der Transistor MP1 ist abgeschaltet.

Beim Übergang des Zustands am Knoten K1 von "1" nach "0" gehen zunächst nur die Transistoren MN1 und MN3 in den Sperrzustand über. Transistor MN2 behält aufgrund der Verzögerungsschaltung VZ1 für eine definierte Verzögerungszeit τ den Zustand "1" bei und ist weiterhin eingeschaltet. Gleichzeitig schaltet der Transistor MP1 ein, so daß der pull-up Zweig MP1, MN2 insgesamt eingeschaltet ist und die Lastkapazität CL über die Serienschaltung aus den Transistoren MN2 und MP1 parallel zum externen 50 Ω Widerstand R geladen wird. Nach der definierten Verzögerungszeit τ, in der die Kapazität umgeladen ist, schaltet auch der Knoten K2 von "1" nach "0", womit der Transistor MN2 abschaltet und damit den pull-up Zweig unterbricht. Ab diesem Zeitpunkt ist nur noch der externe Widerstand R für das Halten des Ausgangspegels zuständig, der jetzt den Zustand "1" hat.

Wechselt nun der Zustand am Knoten K1 wieder von "0" nach "1", schalten die Transistoren MN1 und MN3 ein und der Transistor MP1 schaltet ab. Der Knoten A wird über den Transistor MN1 entladen und in den Zustand "0" verändert. Gleichzeitig wird der Knoten K3 über den Transistor MN3 entladen. Dies muß geschehen noch bevor der Transistor MN2 durch die Verzögerungsschaltung VZ1 einschaltet, da sonst eine Störung am Ausgang A ensteht; für diesen Fall würde der Ausgang A eine kleine Spannungsspitze durch das Entladen des Knotens K3 über den Transistor MN2 bekommen. Nachdem der Ausgang A entladen und der Transistor MN2 eingeschaltet ist, liegt wieder der Anfangszustand vor; die Reihenschaltung aus den Transistoren MN2 und MN3 liegt parallel zum Transistor MN1.

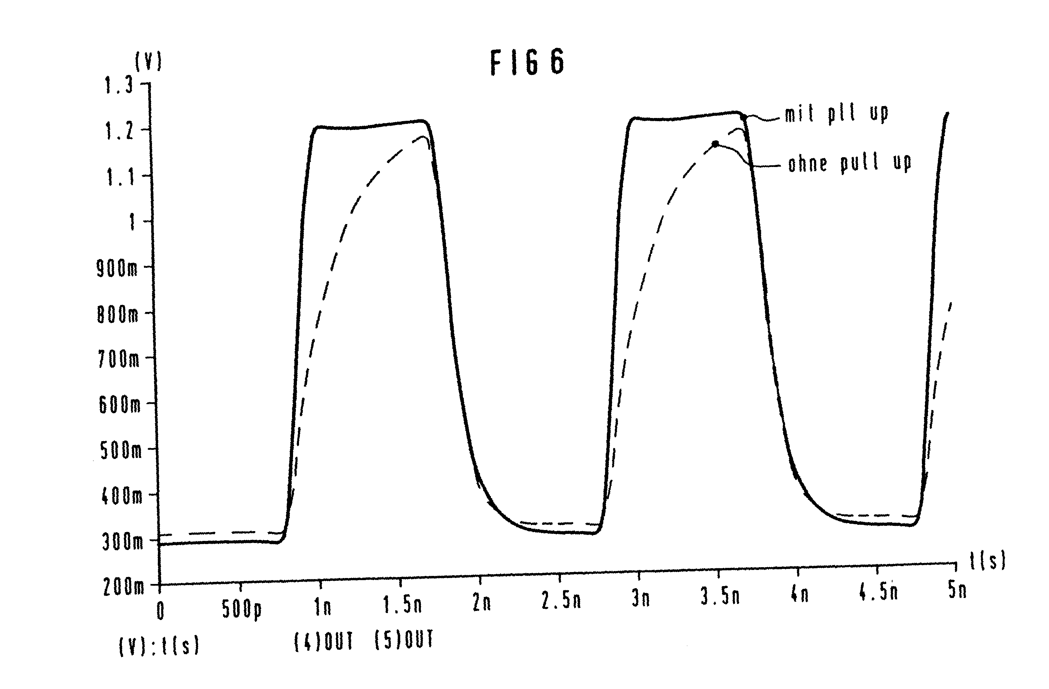

Figur 6 zeigt in einem Diagramm den Verlauf des Potentials am Ausgang aufgetragen über der Zeit t. Ausgezogen dargestellt ist der Verlauf des Ausgangssignals am Ausgang A mit pull-up Transistorschaltung, zum Vergleich dazu gestrichelt der Verlauf des Potentials am Ausgang ohne pull-up Transistorschaltung. Dabei wurde eine kapazitive Last von 5 pF bei einer Frequenz von 500 Mhz und 1 GHz angenommen.

Figur 2 zeigt eine Variante des Ausgangsverstärkers nach Figur 1, hier wird lediglich der Transistor MN2 durch den Transistor MP2, also der n-Kanal Transitor MN2 durch einen p-Kanal Transistor MP2 ersetzt. Dann muß die Verzögerungsschaltung VZ2 entsprechend umgestaltet werden. Die Funktionsweise der beiden Ausgangsverstärker Figur 1, Figur 2 ist aber identisch.

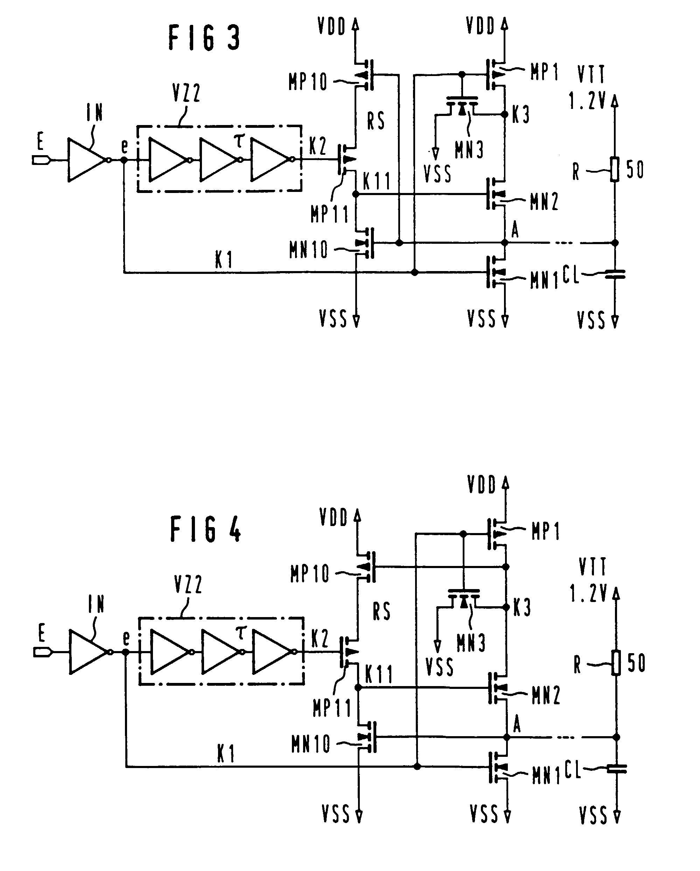

Figur 3 zeigt den Ausgangsverstärker mit einer Regelschaltung RS in der pull-up Transistorschaltung. Die sonstige Schaltung entspricht dem Ausgangsverstärker gemäß Figur 2.

Mit dem Ausgangsverstärker nach Figur 3 wird die Verzögerung τ der Verzögerungsschaltung VZ2 genau auf die Lastkapazität CL abgestimmt, um ein Über- bzw. Unterladen des Ausgangs A zu vermeiden. Umgekehrt ist eine einmal definierte Schaltung nur für eine bestimmte Last optimal einsetzbar. Im folgenden wird die oben beschriebene Schaltung also um die Regelschaltung RS erweitert, die in einem weiten Bereich -unabhängig von der Last- den pull-up Zweig genauso lang öffnet, bis die Lastkapazität CL aufgeladen ist, bzw. der Ausgang A den Zustand "1" erreicht hat.

Die Regelschaltung RS des pull-up Transistorzweiges besteht aus drei Regeltransistoren MN10, MP10 und MP11. In dieser Schaltung wird der pull-up Zweig unterbrochen, wenn der Ausgang A den Zustand "1" erreicht hat bzw. die Verzögerungsschaltung VZ2 anspricht.

Es sei angenommen, daß der Knoten e den Zustand "1", und der Knoten K2 den Zustand "0" hat, dann sind die Transistoren MN1 und MN3 eingeschaltet und der Ausgang A hat den Zustand "0". Gleichzeitig sind die Regelkreistransistoren MP10 und MPll eingeschaltet und der Regeltransistor MN10 ist ausgeschaltet, womit der Knoten K11 den Zustand "1" hat und der Transistor MN2 ebenfalls eingeschaltet ist. Es liegt wieder die Parallelschaltung aus den Transistoren MN2 + MN3 parallel zum Transistor MN1 vor. Der Transistor MP1 ist abgeschaltet.

Wechselt der Zustand am Knoten K1 von "1" nach "0", gehen zunächst wieder die Transistoren MN1 und MN3 in den Sperrzustand und der Transistor MP1 schaltet ein. Der Regeltransistor MPll bleibt aufgrund der Verzögerungsschaltung VZ2 für eine gewisse Zeit leitend, womit der Knoten K11 auf "1" bleibt und damit der pull-up Zweig durch den Transistor MN2 und MP1 angeschaltet ist und die Lastkapazität am Ausgang A über die Parallelschaltung aus dem 50 Ω Widerstand und dem pull-up Zweig aufgeladen werden kann. Wenn die Spannung am Ausgang A die Einsatzspannung des Regeltransistors M10 überschreitet, schaltet der Transistor ein. In dem Maße, wie die Spannung am Ausgang gegen das zweite Potential (high) geht (abhängig von der kapazitiven Last), wird der Knoten K11 gegen "0" gezogen, womit der pull-up Zweig durch Transistor MN2 abgeschaltet wird und ein Überladen des Ausgangs A verhindert wird. Nachdem der pull-up Zweig abgeschaltet ist, übernimmt der 50 Ω Widerstand R wieder das Halten des Ausgangspegels.

Figur 4 zeigt eine Variante der Regelschaltung im Vergleich zu Figur 3, in der der Gate-Anschluß des Regeltransistors MP10 am Knoten K3 gelegt ist. Bei dieser Lösung schaltet der Regeltransistor MP10 besser ab und verringert dadurch die Verlustleistung der gesamten Schaltung.

Sollte die Aufladung der kapazitiven Last CL in der durch die Verzögerungsschaltung VZ2 vorgegebenen Zeit nicht abgeschlossen sein, z.B. wenn **V**_{**TT**} **= 0** oder wegen eines Kurzschlusses am Ausgang A, wodurch der Ausgang unterhalb der Einsatzspannung des Regeltransistors MN10 bleibt und der pull-up Zweig durch die Regelschaltung nicht unterbrochen wird, so schaltet nach der vorgegebenen Verzögerungszeit zunächst der Regeltransistor MP11 ab und unterbricht die Verbindung vom Knoten K11 gegen den Zustand "1". Anschließend wird der Knoten K11 durch den Regeltransistor MN10 entladen und schaltet den Transistor MN2 ab, womit der pull-up Zweig unterbrochen ist.

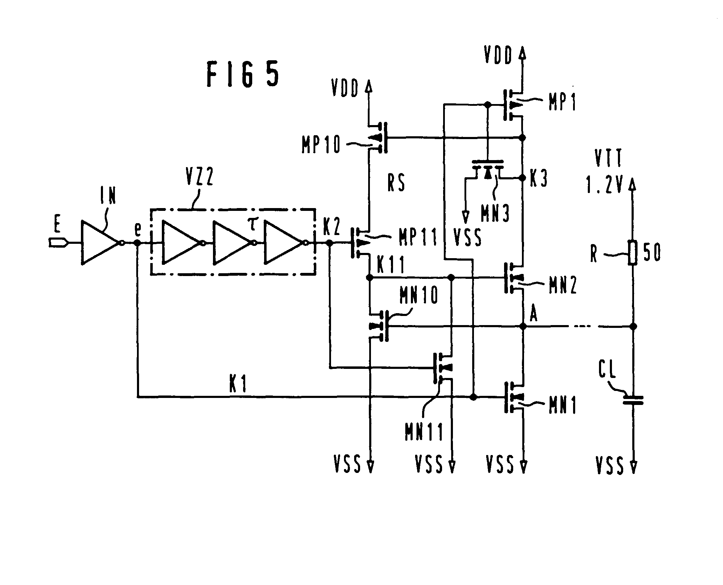

Figur 5 zeigt eine Variante von Figur 4, in der der pull-up Zweig definiert abgeschaltet wird. Nach der durch die Verzögerungszeit τ vorgegebenen Zeit wird der Regeltransistor MP11 abgeschaltet und unterbricht die Verbindung vom Knoten K11 nach "1". Gleichzeitig schaltet der Regeltransistor MN11 ein und zieht den Knoten K11 nach "0".Damit ist der Transistor MN2 abgeschaltet und der pull-up Zweig unterbrochen, sodaß kein Querstrom mehr fließen kann. Dadurch wird verhindert, daß der Baustein durch den pull-up Zweig überlastet wird und Schaden nimmt, bzw. andere Bausteine belastet und eventuell schädigt.

Die in den Figuren dargestellten Transistoren sind MOS-Transistoren, die n-Kanaltransistoren sind mit MN, die p-Kanaltransistoren mit MP bezeichnet, die an den Transistoren anliegenden Betriebspotentiale sind auf übliche Weise mit VDD und VSS bezeichnet.

## Patentansprüche

1. GTL-Ausgangsverstärker zum Einkoppeln eines am Eingang (E) anliegenden Eingangssignals in eine am Ausgang (A) anliegende Übertragungsleitung,
a) bei dem ein pull-down Transistor (MN1) vorgesehen ist, der bei einem ersten Wert ("0") des Eingangssignals (E) ein erstes Potential ("0") an den Ausgang (A) legt,
b) bei dem eine pull-up Transistorschaltung (MP1, MN2) eine Serienschaltung aufweist aus
- einem ersten Transistor (MP1), der bei Anliegen des ersten Wertes ("0") des Eingangssignals (E) gesperrt ist und bei Anliegen eines zweiten Wertes ("1") des Eingangssignals (E) leitend gesteuert ist,
- einem zweiten Transistor (MN2), dessen Eingang mit einer Verzögerungsschaltung (VZ2) verbunden ist und der während einer Übergangsphase des Eingangssignals (E) von dem ersten Wert ("0") zu dem zweiten Wert ("1") für eine durch die Verzögerungsschaltung (VZ) bedingte Zeit (τ) leitend gesteuert bleibt,
c) bei dem die Verzögerungsschaltung (VZ2) zwischen Eingangssignal und dem zweiten Transistor (MN2) 2 vorgesehen ist, wobei die Verzögerungsschaltung (VZ2) bei Eintreten des zweiten Werts ("1") des Eingangssignals (E) und nach Verstreichen der durch die Verzögerungsschaltung (VZ2) bedingten Zeit (τ) den zweiten Transistor (MN2) abschaltet,
d) bei dem zwischen dem Verbindungspunkt der beiden Transistoren (MP1, MN2) der Serienschaltung ein dritter Transistor (MN3) angeschlossen ist, der bei dem ersten Wert ("0") des Eingangssignals (E) leitend gesteuert ist,
e) bei dem die pull-up Transistorschaltung (MP1, MN2) durch eine Regelschaltung (MN10, MP11, MP10) ergänzt ist, die einen ersten Regeltransistor (MP10), einen zweiten Regeltransistor (MP11) und einen dritten Regeltransistor (MN10) umfasst und den zweiten Transistor (MN2) sperrt, wenn der dritte Regeltransistor (MN10) der Regelschaltung, sobald das Potential des Ausgangs (A) die Einsatzspannung des dritten Regeltransistors (MN10) überschreitet, leitend gesteuert ist.

2. Ausgangsverstärker nach Anspruch 1, bei dem die. Regelschaltung aus einer Serienschaltung des ersten Regeltransistors (MP10), des zweiten Regeltransistors (MP11) und des dritten Regeltransistors (MN10) besteht
a) bei der der zweite Regeltransistor (MP11) mit dem Ausgang der Verzögerungsschaltung (VZ2) verbunden ist, der Verbindungspunkt des zweiten Regeltransistors (MP11) und des dritten Regeltransistors (MN10) mit dem Eingang des zweiten Transistors (MN2) der Transistorschaltung verbunden ist,
b) bei dem der Eingang des dritten Regeltransistors (MN10) mit dem Ausgang (A) verbunden ist
c) und bei dem der erste Regeltransistor (MP10) mit dem Verbindungspunkt zwischen dem ersten und dem zweiten Transistor der Transistorschaltung verbunden ist.

3. Ausgangsverstärker nach Anspruch 1, bei dem die Regelschaltung aus einer Serienschaltung des ersten Regeltransistors (MP10), des zweiten Regeltransistors (MP11) und des dritten Regeltransistors (MN10) besteht,
a) bei dem der Eingang des ersten Regeltransistors (MP10) mit dem Ausgang (A) verbunden ist,
b) bei dem der Eingang des zweiten Regeltransistors (MP11) mit dem Ausgang der Verzögerungsschaltung (VZ2) verbunden ist,
c) bei dem der Eingang des dritten Regeltransistors (MN10) mit dem Ausgang (A) verbunden ist und bei dem der Verbindungspunkt des zweiten Regeltransistors und des dritten Regeltransistors mit dem Eingang des zweiten Transistors (MN2) der Transistorschaltung verbunden ist.

4. Ausgangsverstärker nach Anspruch 2, bei dem parallel zum dritten Regeltransistor (MN10) ein vierter Regeltransistor (MN11) geschaltet ist, dessen Eingang mit dem Ausgang der Verzögerungsschaltung (VZ) verbunden ist und der in Abhängigkeit der Verzögerungszeit (τ) der Verzögerungsschaltung den zweiten Transistor (MN2) der Transistorschaltung sperrt.

## Claims

1. GTL output amplifier for coupling an input signal present at the input (E) into a transmission line present at the output (A),
a) in which a pull-down transistor (MN1) is provided, which applies a first potential ("0") to the output (A) in the event of a first value ("0") of the input signal (E),
b) in which a pull-up transistor circuit (MP1, MN2) has a series circuit formed by
- a first transistor (MP1), which is switched off in the presence of the first value ("0") of the input signal (E) and is switched on in the presence of a second value ("1") of the input signal (E),
- a second transistor (MN2), whose input is connected to a delay circuit (VZ2) and which remains switched on for a time (τ) which is governed by the delay circuit (VZ), during a transition phase of the input signal (E) from the first value ("0"), to the second value
c) in which the delay circuit (VZ2) is provided between input signal and the second transistor (MN2), the delay circuit (VZ2) switching off the second transistor (MN2) when the second value ("1") of the input signal (E) occurs and after the time (τ) governed by the delay circuit (VZ2) has elapsed,
d) in which a third transistor (MN3) is connected between the junction point of the two transistors (MP1, MN2) of the series circuit and is switched on in the event of the first value ("0") of the input signal (E),
e) in which the pull-up transistor circuit (MP1, MN2) is supplemented by a control circuit (MN10, MP11, MP10), which comprises a first control transistor (MP10), a sesond control transistor (MP11) and a third control transistor (MN10) and switches the second transistor (MN2) off when the third control transistor (MN10) of the control circuit is switched on as soon as the potential of the output (A) exceeds the threshold voltage of the third control transistor (MN10).

2. Output amplifier Claim 1, in which the control circuit comprises a series circuit formed by the first control transistor (MP10), the second control transistor (MP11) and the third control transistor (MN10),
a) in which the second control transistor (MP11) is connected to the output of the delay circuit (VZ2), and the junction point between the second control transistor (MP11) and the third control transistor (MN10) is connected to the input of the second transistor (MN2) of the transistor circuit,
b) in which the input of the third control transistor (MN10) is connected to the output (A),
c) and in which the first control transistor (MP10) is connected to the junction point between the first and the second transistor of the transistor circuit.

3. Output amplifier as claimed in Claim 1, in which the control circuit comprises a series circuit formed by the first control transistor (MP10), the second control transistor (MP11) and the third control transistor (MN10),
a) in which the input of the first control transistor (MP10) is connected to the output (A),
b) in which the input of the second control transistor (MP11) is connected to the output of the delay circuit (VZ2),
c) in which the input of the third control transistor (MN10) is connected to the output (A), and in which the junction point between the second control transistor and the third control transistor is connected to the input of the second transistor (MN2) of the transistor circuit.

4. Output amplifier as claimed in Claim 2, in which a fourth control transistor (MN11) is connected in parallel with the third control transistor (MN10), the input of said fourth control transistor being connected to the output of the delay circuit (VZ) and said fourth control transistor switching off the second transistor (MN2) of the transistor circuit as a function of the delay time (τ) of the delay circuit.

## Revendications

1. Amplificateur de sortie GTL pour injecter un signal d'entrée se trouvant à une entrée (E) dans une ligne de transmission située à la sortie (A),
a. dans lequel un transistor pull-down (MN1) engendre un premier potentiel (« 0 ») à la sortie (A) pour une première valeur (« 0 ») du signal d'entrée (E),
b. dans lequel un circuit pull-up transistorisé (MP1, MN2) intègre un montage en série comportant :
- un premier transistor (MP1), qui est bloqué à la requête de la première valeur (« 0 ») du signal d'entrée (E) et qui devient conducteur à la requête d'une deuxième valeur (« 1 ») du signal d'entrée (E),
- un deuxième transistor (MN2), dont l'entrée est reliée à un circuit de retardement (VZ2), qui continue à être conducteur pendant un temps (τ) défini par le circuit de retardement (VZ) lors d'une phase de transition au cours de laquelle le signal d'entrée (E) passe de la première valeur (« 0 ») à la deuxième valeur (« 1 »);
c. dans lequel un circuit de retardement (VZ2) est prévu entre le signal d'entrée et le deuxième transistor (MN2), le circuit de retardement (VZ2) désexcitant le deuxième transistor (MN2) lorsque la deuxième valeur (« 1 ») du signal d'entrée (E) intervient et après écoulement du temps (τ ) déterminé par le circuit de retardement (VZ2) ;
d. dans lequel un troisième transistor (MN3) est relié entre le point de jonction des deux transistors (MP1, MN2) du montage en série, qui reste conducteur en présence de la première valeur (« 0 ») du signal d'entrée (E);
e. dans lequel le circuit pull-up transistorisé (MP1, MN2) est complété par un circuit de réglage (MN10, MP11, MP10) qui comporte un premier transistor de réglage (MP10), un deuxième transistor de réglage (MP11) ainsi qu'un troisième transistor de réglage (MN10) et qui bloque le deuxième transistor (MN2) lorsque le troisième transistor de réglage (MN10) du circuit de réglage devient conducteur dès que le potentiel de la sortie (A) dépasse la tension d'utilisation du troisième transistor de réglage (MN10) ;

2. Amplificateur de sortie selon la revendication 1 dans lequel le circuit de réglage comporte un montage en série du premier transistor de réglage (MP10), du deuxième transistor de réglage (MP11) et du troisième transistor de réglage (MN10),
a. dans lequel le deuxième transistor de réglage (MP11) est relié à la sortie du circuit de retardement (VZ2), le point de jonction du deuxième transistor de réglage (MP11) et du troisième transistor de réglage (MN10) est relié à l'entrée du deuxième transistor (MN2) du circuit transistorisé,
b. dans lequel l'entrée du troisième transistor de réglage (MN10) est reliée à la sortie (A),
c. et dans lequel le premier transistor de réglage (MP10) est relié au point de jonction entre le premier et le deuxième transistor du circuit transistorisé ;

3. Amplificateur de sortie selon la revendication 1 dans lequel le circuit de réglage comporte un montage en série du premier transistor de réglage (MP10), du deuxième transistor de réglage (MP11) et du troisième transistor de réglage (MN10),
a. dans lequel l'entrée du premier transistor de réglage (MP10) est reliée à la sortie (A),
b. dans lequel l'entrée du deuxième transistor de réglage (MP11) est reliée à la sortie du circuit de retardement (VZ2) ;
c. dans lequel l'entrée du troisième transistor de réglage (MN10) est reliée à la sortie (A) et en ce que le point de jonction du deuxième transistor de réglage et du troisième transistor de réglage est relié à l'entrée du deuxième transistor (MN2) du circuit transistorisé.

4. Amplificateur de sortie selon la revendication 2 dans lequel un quatrième transistor de réglage (MN11) dont l'entrée est reliée à la sortie du circuit de retardement (VZ) est branché en parallèle avec le troisième transistor de réglage (MN10) et bloque le deuxième transistor (MN2) du circuit transistorisé en fonction du temps de retardement (τ) du circuit de retardement.
